Europäisches Patentamt

European Patent Office

Office européen des brevets

(19)

(11) Veröffentlichungsnummer: **0 198 999**

**A2**

(12) **EUROPÄISCHE PATENTANMELDUNG**

(21) Anmeldenummer: **86100966.0**

(22) Anmeldetag: **24.01.86**

(51) Int. Cl.⁴: **H 03 G 5/02**
**G 05 B 11/01**

(30) Priorität: **20.04.85 DE 3514427**

(43) Veröffentlichungstag der Anmeldung:
**29.10.86 Patentblatt 86/44**

(84) Benannte Vertragsstaaten:
**AT DE GB**

(71) Anmelder: **ANT Nachrichtentechnik GmbH**
**Gerberstrasse 33**
**D-7150 Backnang(DE)**

(72) Erfinder: **Schütte, Holger, Dipl.-Ing.**
**Tannenweg 16**
**D-3340 Wolfenbüttel(DE)**

(74) Vertreter: **Wiechmann, Manfred, Dipl.-Ing.**
**ANT Nachrichtentechnik GmbH Gerberstrasse 33**
**D-7150 Backnang(DE)**

(54) **Pegelsteller mit einem Motor zur Reproduzierung eingestellter Pegelwerte.**

(57) Pegelsteller mit folgenden Merkmalen:
- er weist eine translatorisch bewegbare Handhabe (4) zur manuellen Pegelstellung auf,
- er weist ein über die Handhabe (4) beeinflußbares Pegelstellglied auf,
- er weist einen mit der Handhabe (4) gekuppelten Stellungsgeber (5, 7) auf zur Abgabe von abzuspeichernden Stellungssignalen, die repräsentativ sind für den in jeder Stellung eingestellten Pegel,
- er weist einen Motor (9) zur motorischen Bewegung der Handhabe (4) bei der Reproduktion früher abgespeicherter Pegeleinstellungen auf.

Zur Verminderung von Störeinflüssen (beispielsweise Staub und elektrische und magnetische Störeinstreuungen vom Motor 9) ist das Pegelstellglied (14) von der Handhabe (4) mechanisch entkoppelt und bei manueller Pegelstellung durch die Stellungssignale des Stellungsgebers (5, 7) steuerbar. Darüber hinaus kann zur möglichst verzögerungsarmen Reproduktion von gespeichert gewesenen Pegelstellungen das abgespeicherte, wieder ausgelesene und digital/analog gewandelte Stellungssignal (24) über einen Zweig (21–22–23) einer Steuerschaltung den Motor (9) und damit die Handhabe (4) steuern und über einen anderen, im Signalfluß hinter einem D/A–Wandler 27 abzweigenden Zweig (16–17) das Pegelstellglied (14) steuern.

Fig. 3

## Pegelsteller mit einem Motor zur Reproduzierung
## eingestellter Pegelwerte

Die Erfindung betrifft einen Pegelsteller mit den Merkmalen des Oberbegriffes des Patentanspruches 1. Er kann zur Einstellung des Pegels elektrischer Schwingungsgemische beispielsweise in Tonstudios dienen.

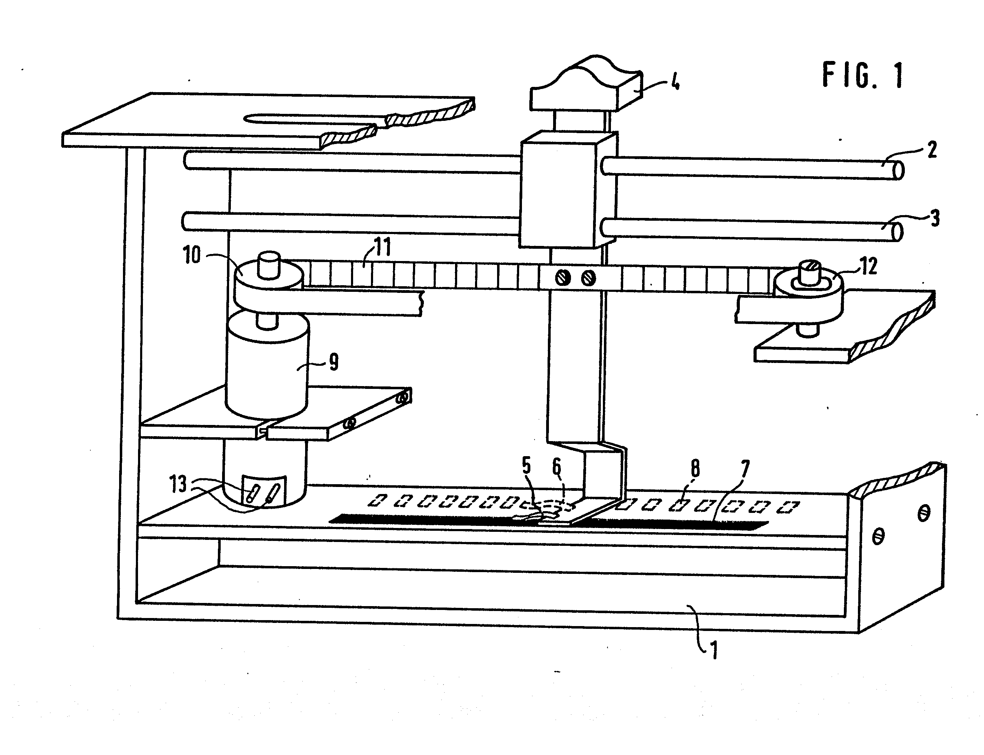

Ein solcher Pegelsteller befindet sich im Handel. Eine Prinzipdarstellung von ihm zeigt Figur 1. In einem Gehäuse 1 sind zwei Führungsstangen 2 und 3 fest angeordnet, auf denen eine Handhabe 4 translatorisch bewegbar ist, mit der zwei Stellglieder mechanisch gekuppelt sind, nämlich zwei Schleifer 5, 6, die auf zwei Schleiferbahnen 7, 8 gleiten und damit je ein Flachbahnpotentiometer bilden. Eines dieser beiden Potentiometer bildet den eigentlichen Pegelsteller, während das andere als Stellungsgeber dient. Die vom Stellungsgeber abgreifbare Spannung ist ein Maß für die jeweilige Stellung der Handhabe 4. Diese Spannung kann (bevorzugt digital) gespeichert werden. Sie dient nach Abspeicherung und Wiederauslesung zur Steuerung eines Motors 9 über dessen Motorklemmen 13, der über einen Zahnriemen 11 (der über eine Umlenkrolle 12 geführt ist) die Handhabe 4 jeweils so lange antreibt, bis die Spannung an dem ebenfalls mit der Handhabe 4 verbundenen Schleifer 5 des Stellungsgebers 5, 7 mit der ausgelesenen Spannung übereinstimmt. Auf diese Weise ist die bei der Einspeicherung vorhanden gewesene Stellung der Handhabe 4 wieder erreicht.

Der bekannte Pegelsteller hat sich in mancher Beziehung als störanfällig erwiesen, denn das Flachbahnpotentiometer 6, 8, über welches die Nutzsignale (das bezüglich seines Pegels einzustellende, insbesondere tonfrequente Schwingungsgemisch) geführt werden, ist unzureichend staubgeschützt und den elektrischen Störeinstreuungen ausgesetzt, die vom Motor 9,

0198999
BK 85729

seinen Motorklemmen und deren Zuleitungen ausgehen.

Die Aufgabe der vorliegenden Erfindung besteht darin, einen störungsfreieren Betrieb eines Pegelstellers zu ermöglichen.

Dies wird ermöglicht durch den Pegelsteller mit den Merkmalen des Patentanspruches 1. Vorteilhafte Weiterbildungen sind in den Unteransprüchen angegeben.

Dadurch daß das der eigentlichen Pegelstellung dienende Flachbahnpotentiometer 6, 8 (Figur 1) durch ein Pegelstellglied ersetzt ist, das von der Handhabe 4 mechanisch entkoppelt ist und das bei manueller Pegelstellung durch die Steuersignale des Stellungsgebers 5, 7 (elektrisch) steuerbar ist, läßt sich folgendes erreichen: Das Pegelstellglied, bevorzugt ein bezüglich seiner Verstärkung spannungsgesteuerter Verstärker (VCA), ist gegen Verstaubung unempfindlicher und läßt sich gegen Verstaubung auch leichter schützen als ein Flachbahnpotentiometer; er läßt sich auch auf relativ einfache Weise so elektrisch und magnetisch abschirmen, daß er gegen Einstreuungen durch Ströme in oder zu dem Motor 9 unempfindlich ist.

Wenn zudem noch das Pegelstellglied außerhalb desjenigen Gehäuses angeordnet ist, das für den Stellungsgeber und den Motor vorgesehen ist, so ist eine noch größere Sicherheit gegen Störeinstreuungen gegeben. Es wird sogar noch ein zusätzlicher konstruktiver Freiheitsgrad gewonnen, weil das Pegelstellglied auch in beträchtlicher Entfernung von dem Gehäuse mit dem Motor und dem Stellungsgeber angeordnet werden kann.

Anhand der Zeichnungen wird noch näher auf die Erfindung eingegangen und es werden bevorzugte Ausführungsbeispiele beschrieben.

0198999

Figur 1 zeigt (abgesehen von den mit unterbrochenen Linien
dargestellten Teilen) den mechanischen und elektromechanischen Teil eines Pegelstellers nach der Erfindung,

Figur 2 zeigt ein Blockschaltbild eines bevorzugten Ausführungsbeispieles mit Peripherie und die

Figuren 3 und 4 stellen abgewandelte Blockschaltbilder dar.

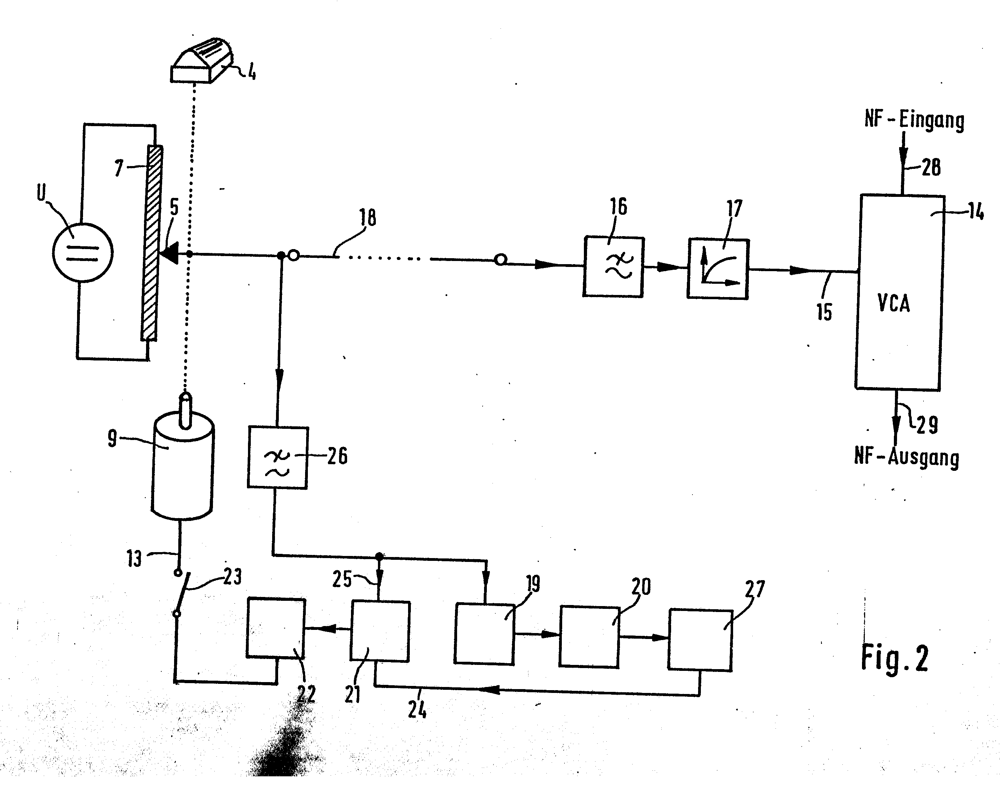

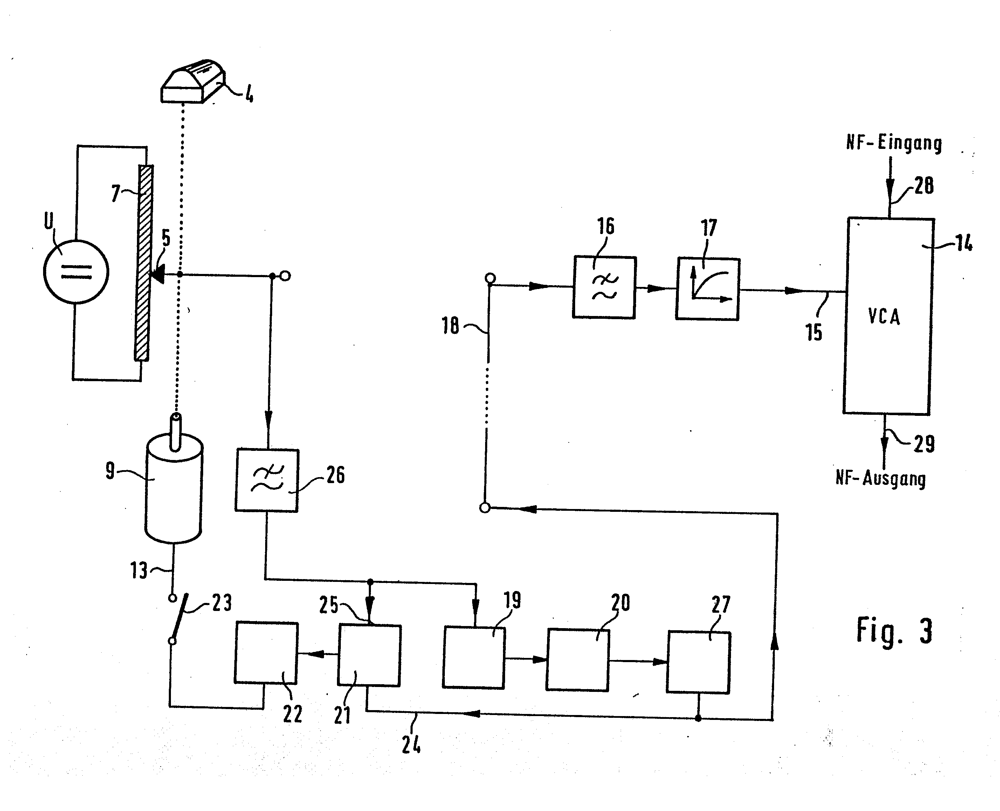

Figur 1 wurde schon oben im Zusammenhang mit dem Stand der
Technik beschrieben; gemäß der Erfindung entfällt nun das
Flachbahnpotentiometer 6, 8 zu Gunsten eines in Figur 1
nicht dargestellten Pegelstellgliedes, das vom Stellungsgeber 5, 7 elektrisch steuerbar ist. Bei dem Stellungsgeber
5, 7 muß es sich nicht, wie dargestellt, um ein Flachbahnpotentiometer handeln, es kann sich vielmehr auch um irgend
einen anderen Stellungsgeber, beispielsweise einen optischen
(vgl. z.B. DE-PS 22 32 035) handeln. In den Figuren 2 und 3
wird jedoch der Einfachheit halber von dem in Figur 1 gezeigten Ausführungsbeispiel ausgegangen.

Die wichtigsten Teile der Anordnung nach Figur 1 (ohne die
unterbrochen gezeichneten Teile) sind in Figur 2 mit denselben Bezugsziffern wiedergegeben. An der Schleiferbahn (7)
liegt eine Gleichspannung U, die vom Schleifer abgenommen
wird und je nach Stellung der Handhabe 4 einen dem Weg proportionalen Wert aufweist. Durch diese Spannung ist es möglich, die Position der Handhabe 4 zu erkennen. Diese Spannung dient dazu, über einen Analog-Digital-Wandler 19, dem
ein Tiefpaßfilter 26 zum Herausfiltern von Störungen vorgeschaltet ist, einem Speicher in einem Rechner 20 die jeweilige Position der Handhabe 4 mitzuteilen, wenn diese von
Hand bewegt wird, und für eine spätere Reproduktion abzuspeichern. Soll eine Stellung oder Bewegung der Handhabe 4
durch Rechnersteuerung und Motorantrieb reproduziert werden, wird der Motor 9 elektrisch oder/und mechanisch an das
Stellsystem angekoppelt (Schalter 23) und der Rechner 20 gibt über einen Digital/Analog-Wandler 27 einen Sollwert 24 vor, der mit der Position der Handhabe, dargestellt durch den Schleiferistwert 25, in einer Regelschaltung 21 verglichen wird und über eine Treiberstufe 22 den Motor zu entsprechender Reaktion veranlaßt.

Neu ist dabei, daß keine separate Niederfrequenzschleiferbahn 8 mit Schleifer 6 zum Stellen des Niederfrequenzpegels benutzt wird, sondern die mit dem Schleifer 5 abgegriffene Gleichspannung dazu dient, ein spannungsgesteuertes Pegelstellglied 14, nämlich einen spannungsgesteuerten Verstärker (VCA) über einen Steuereingang 15 in seiner Verstärkung zu stellen. Zwischen Schleifer 5 und Steuereingang 15 des VCA können noch verschiedene elektronische Geräte geschaltet sein. Eine Möglichkeit ist ein Tiefpaßfilter 16 zur Unterdrückung von in die Steuerleitung 18 eingestreuten Störungen und/oder ein Funktionsnetzwerk 17 z.B. zur Anpassung der Stellkennlinie an die der bisher verwendeten konventionellen Flachbahnpegelsteller. Durch die Möglichkeit, die Steuerleitung 18 sehr lang, z.B. 100 m, ausführen zu können, entsteht der Vorteil, den VCA 14 von Motor und Handhabe abgesetzt zu installieren, so daß keine Störungen vom Motor 9 direkt in den Niederfrequenzweg 28-29 eingestreut werden können und der VCA 14 an der räumlich und elektrisch günstigsten Stelle plaziert werden kann.

Ein anderes Ausführungsbeispiel ist in Figur 3 dargestellt. Sie dient dazu, alle oben genannten Vorteile zu verwirklichen und zusätzlich folgenden Nachteil zu beseitigen: Ist die durch den Motor 9 erzielbare maximale Stellgeschwindigkeit geringer als die manuelle Stellgeschwindigkeit, so speichert zwar der Rechner 20 (ausreichende Rechengeschwindigkeit vorausgesetzt) die schnelle manuelle Stellbewegung ab, bei der Wiederholung des Stellvorganges durch den Rechner und den Motor aber, wird bei einem Pegelsteller nach dem Stand der Technik (Figur 1) mit den unterbrochen gezeichneten Teilen) sowohl die Einstellung der Handhabe 4 als auch des mechanisch damit gekuppelten Schleifers 6 des Pegelstellpotentiometers 6, 8 nur mit verminderter Geschwindigkeit ausgeführt. Es findet also nicht in allen Fällen eine genaue Reproduzierung insbesondere schneller Bewegungen des Schleifers 5 statt. Dieser Nachteil ist auch noch bei dem Ausführungsbeispiel nach Figur 2 gegeben, bei dem ja das Pegelstellglied 14 auch bei motorischer Bewegung der Handhabe 4 durch die Stellungssignale des gekuppelten Stellungsgebers 5 steuerbar ist.

In dem Beispiel nach Figur 3 ist dieser Nachteil beseitigt. Der VCA wird hier nicht direkt durch die Stellungssignale des Schleifers 5 gesteuert, sondern über einen Zweig mit einem Digital/Analogwandler 27 direkt vom Rechner 20. Da der Rechner 20 Stellbewegungen von Hand, die in der Zeit $t_1$ stattfinden und schneller sind als die maximale Stellgeschwindigkeit des Stellers bei Motorbetrieb, in der Zeit $t_1$ abspeichern und ebenso schnell wieder auslesen kann, der Motor aber für die gleiche Stellstrecke die längere Zeit $t_2$ benötigt, ergibt sich bei der Direktsteuerung des VCA's 14 durch den Rechner 20 bei Rechnerbetrieb eine genauere Reproduzierbarkeit des Niederfrequenzstellvorganges mit dem Zeitgewinn $\Delta t = t_2 - t_1$ (für $t_2 > t_1$ s.o.).

Ein weiterer Vorteil dieser Ausführungsform besteht darin, daß sie es erlaubt, die Positionierung der Handhabe 4 ungenauer durchzuführen, d.h. Restabweichungen oder geringe Überschwinger zuzulassen, um Aufwand in der Regelelektronik zu sparen; denn die Genauigkeit des Pegelstellvorganges des VCA ist beim Pegelsteller nach Figur 3 nur von der Genauigkeit der Rechnerausgabe abhängig. Die Handhabe 4 dient dann lediglich als mechanischer Stellwertanzeiger, dessen Anzeigegenauigkeit nicht besonders bedeutungsvoll ist.

Es ist auch eine zwischen oben dargestellten Ausführungen nach den Figuren 2 und 3 umschaltbare Version denkbar, z.B.

0198999

für Havariebetrieb bei Rechnerausfall. Umgeschaltet wird dann die Leitung 18.

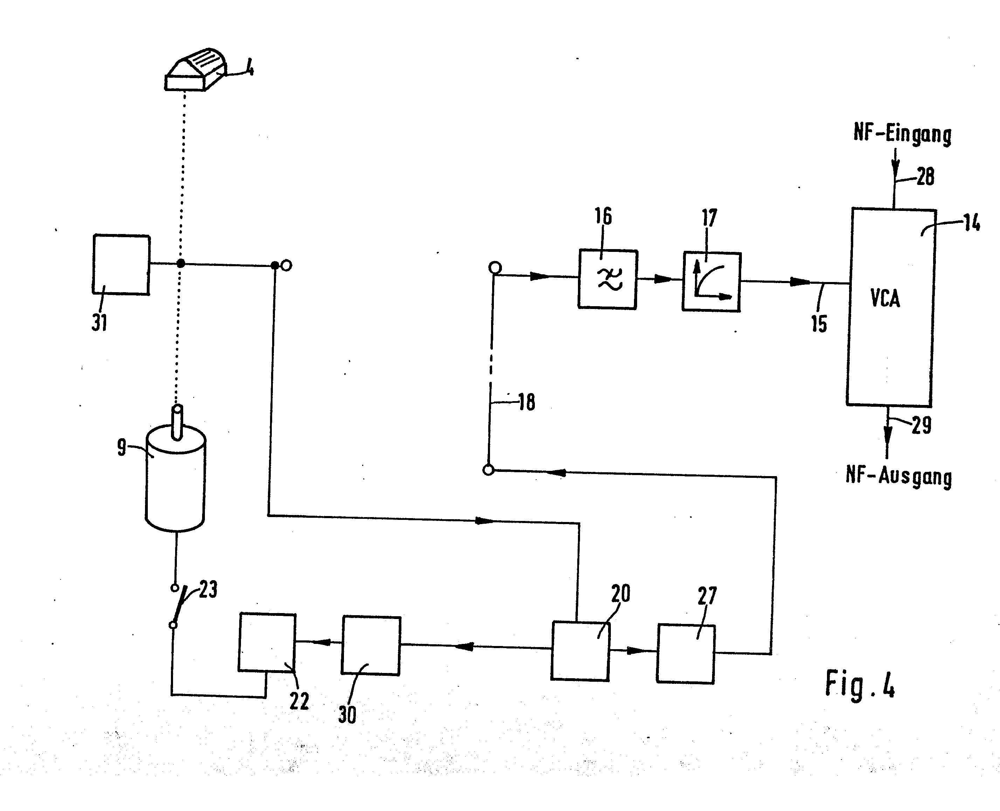

Unterstützt durch Figur 4 sei nochmals darauf hingewiesen, daß an die Stelle des Potentiometers 7, 5 mit der Spannungsquelle U auch ein anderer Stellungsgeber, insbesondere ein Impulsgeber 31 treten kann. Dann kann das Tiefpaßfilter 26 (Fig. 2 und 3) entfallen, ebenso der A/D-Wandler 19; allerdings ist in diesem Fall zwischen dem Rechner 20 und dem Treiber 22 ein D/A-Wandler 30 vorzusehen. Der Rechner 20 übernimmt dann zusätzlich die Funktion des in den Figuren 2 und 3 vorgesehenen Reglers 25.

- - - - -

0198999

7
- 7 -

ANT Nachrichtentechnik GmbH                    E7/Wn/kön
Gerberstraße 33                                BK 85/29
D-7150 Backnang


Patentansprüche


1. Pegelsteller mit folgenden Merkmalen:
   - er weist eine translatorisch bewegbare Handhabe (4) zur manuellen Pegelstellung auf,
   - er weist ein über die Handhabe (4) beeinflußbares Pegelstellglied auf,
   - er weist einen mit der Handhabe (4) gekuppelten Stellungsgeber (5, 7) auf zur Abgabe von abzuspeichernden Stellungssignalen, die repräsentativ sind für den in jeder Stellung eingestellten Pegel,
   - er weist einen Motor (9) zur motorischen Bewegung der Handhabe (4) bei der Reproduktion früher abgespeicherter Pegeleinstellungen auf,
   gekennzeichnet durch folgende Merkmale:
   - das Pegelstellglied (14) ist von der Handhabe (4) mechanisch entkoppelt und bei manueller Pegelstellung durch die Stellungssignale des Stellungsgebers (5, 7) steuerbar.


2. Pegelsteller nach Anspruch 1, dadurch gekennzeichnet, daß sich das Pegelstellglied (14) außerhalb desjenigen Gehäuses (1) befindet, das für den Stellungsgeber (5, 7) und den Motor (9) vorgesehen ist.

3. Pegelsteller nach Anspruch 1 oder 2, dadurch gekennzeichnet,
daß das Pegelstellglied (14) auch bei motorischer Bewegung der Handhabe (4) durch die Stellungssignale des gekuppelten Stellungsgebers (5, 7) steuerbar ist.

4. Pegelsteller nach Anspruch 1 oder 2, dadurch gekennzeichnet,
daß die abgespeicherten und wieder ausgelesenen Stellungssignale (24) über einen Zweig (21-22-23) einer Steuerschaltung den Motor (9) und damit die Handhabe (4) steuern und über einen anderen, im Signalfluß vor dem Motor (9) abzweigenden Zweig (16-17) das Pegelstellglied (14) steuern.

5. Pegelsteller nach Anspruch 4, dadurch gekennzeichnet, daß die wieder ausgelesenen Stellungssignale (24) einem Digital/Analog-Wandler (27) zugeführt werden, von welchem die beiden Zweige (21-22-23) und 16-17) der Steuerschaltung ausgehen.

FIG. 1

Fig. 2

Fig. 3

NF-Eingang

28

14

VCA

15

16

17

18

26

9

13

23

22

21

24

25

19

20

27

U

7

5

4

29

NF-Ausgang

BK 85/

0198999

Fig. 4

NF-Eingang

NF-Ausgang

VCA

31

9

23

22

30

20

27

16

17

15

18

14

28

29

4

4/4

0198999

RK 85/29